Europäisches Patentamt

European Patent Office

Office européen des brevets

(11) Publication number: **0 314 132**
**A2**

## EUROPEAN PATENT APPLICATION

(21) Application number: 88117930.3

(22) Date of filing: 27.10.88

(51) Int. Cl.4: **C08F 4/32 , C08F 299/02 ,**
**C08F 299/04 , C08F 299/06 ,**
**C09J 3/14 , H05K 1/03**

(30) Priority: 27.10.87 JP 270567/87

(43) Date of publication of application:
**03.05.89 Bulletin 89/18**

(84) Designated Contracting States:
**DE GB**

(71) Applicant: **SOMAR CORPORATION**
**11-2, Ginza 4-chome Chuo-ku**
**Tokyo(JP)**

(72) Inventor: **Fujii, Ryuichi**
**33-8-10-206, Harayama 2-chome**
**Urawa-shi Saitama(JP)**
Inventor: **Kawano, Takayuki**
**250-43, Fujizuka**
**Kasukabe-shi Saitama(JP)**

(74) Representative: **Hansen, Bernd, Dr.rer.nat. et**
**al**
**Hoffmann, Eitle & Partner Patentanwälte**
**Arabellastrasse 4 Postfach 81 04 20**
**D-8000 München 81(DE)**

(54) **Curable composition.**

(57) A curable composition is disclosed, comprising a polymerizable prepolymer, a reactive diluent, a photopolymerization initiator, and a heat polymerization initiator, wherein said heat polymerization initiator is a mixed system containing from 10 to 50% by weight, based on the whole of the heat polymerization initiator, of an alkyl perester. The curable composition is curable with a heat or a light and is useful as an adhesive for surface mounting components.

EP 0 314 132 A2

## CURABLE COMPOSITION

## FIELD OF THE INVENTION

This invention relates to a curable composition which is cured by the function of heat and/or light and which can suitably be used as an adhesive for surface mounting components (hereinafter "SMC").

## BACKGROUND OF THE INVENTION

Hitherto, as adhesives for SMC, which are used for adhering and fitting printed circuit boards with SMC such as chip resistors, chip capacitors, etc., those having various formulations have been known.

In such adhesives, for example, a photopolymerization initiator and a heat polymerization initiator are used in combination as a polymerization initiator and an organic peroxide is used as the heat polymerization initiator, as disclosed in JP-A-58-101107, JP-A-59-223775 and JP-B-59-5226. (The terms "JP-A" and "JP-B" as used herein mean an "unexamined published Japanese patent application" and an "examined Japanese patent publication", respectively.)

However, the adhesives in which the heat polymerization initiator is an organic peroxide are so inferior in storage stability at room temperature that in order to keep the good storage stability over such a long period of time as one month or more, the heating at the time of curing of the adhesive must be carried out at high temperatures of at least 150° C.

## SUMMARY OF THE INVENTION

An object of this invention is to overcome the above-described defects accompanied with the prior art techniques and provide a curable composition which is suitable as an adhesive for adhering and fitting printed circuit boards with SMC.

This invention relates to a curable composition comprising a polymerizable prepolymer, a reactive diluent, a photopolymerization initiator, and a heat polymerization initiator, wherein said heat polymerization initiator is a mixed system containing from 10 to 50% by weight, based on the whole of the heat polymerization initiator, of an alkyl perester.

The curable composition of this invention exhibits good storage stability at room temperature over a long period of time and is readily curable at a low temperature as about 100 to 120° C to impart firm adhesion.

In the curable composition of the present invention, each of the components can be used either alone or in admixuture of two or more thereof.

## DETAILED DESCRIPTION OF THE INVENTION

Examples of the polymerizable prepolymer which can be used in this invention include unsaturated polyesters, epoxy (meth)acrylates, urethane (meth)acrylates, oligoester (meth)acrylates, etc.

The above-described unsaturated polyesters are polyesters having a molecular weight of from 1,000 to 10,000 and containing therein ethylenically unsaturated bonds and are commerically available under the trade names of, for example, Upica® 8554 (made by Nippon Upica Co., Ltd.) and New Track® 410 S (made by Kao Corporation).

The above-described epoxy (meth)acrylates are products obtained by esterifying epoxy resins having bisphenol A, phenol or cresol novolak as a skeleton with (meth)acrylic acid and are commercially available under the trade names of, for example, Ripoxy® SP-1509 and SP-4010 (made by Showa Highpolymer Co., Ltd.).

The above-described urethane (meth)acrylates are generally obtained by reacting a diol such as

2

aliphatic diols (e.g., ethylene glycol, etc.), ether diols having two hydroxyl groups at the ether chain terminal ends, and ester diols having two hydroxyl groups at the ester chain terminal ends with a stoichiometric excess of a diisocyanate such as toluene diisocyanate, isophorone diisocyanate, etc. to form a urethane compound having isocyanato groups at the terminal ends which is then further reacted with a hydroxyalkyl (meth)acrylate. Commercial products are available under the trade names of, for example, Uvithane® 893 (made by Thiochol Chemical Corp.) and U-6HA (made by Shin Nakamura Kagaku Kogyo Co., Ltd.).

The above-described oligoester (meth)acrylates are polyfunctional (meth)acrylates having, as a skeleton, an ester compound obtained from aromatic carboxylic acids and are commerically available under the trade names of, for example, Aronix® M-8060 and M-7100 (made by Toagosei Chemical Industry Co., Ltd.).

The reactive diluent which is used in this invention is added for the purpose of adjusting the viscosity of the curable composition or characteristics of cured products, and examples thereof include polyfunctional (meth)acrylates, monofunctional (meth)acrylates, etc.

Examples of the above-described polyfunctional (meth)acrylates include trimethylolpropane tri(meth)-acrylate, pentaerythritol tetra(meth)acrylate, dipentaerythritol hexa(meth)acrylate, tris(acryloxyethyl) isocyanurate, 1,6-hexanediol diacrylate, triethylene glycol diacrylate, neopentyl glycol diacrylate, polyethylene glycol diacrylate, hydroxypivalic acid, neopentyl glycol diacrylate, (meth)acrylated compounds of bisphenol A having ethylene oxide added thereto, and diglycidyl ester di(meth)acrylates of dibasic fatty acids containing 4 or more carbon atoms. Commercial products are available under the trade names of, for example, Viscoat® #3700 and #700 (made by Osaka Yuki Co., Ltd.), MANDA® (made by Nippon Kayaku Co., Ltd.), Aronix® M6100, M6300 and TD-1600A (made by Dainippon Ink and Chemicals, Inc.), and ULB-20GEA (Okamura Seiyu Co., Ltd.).

Examples of the above-described monofunctional (meth)acrylates include hydroxyethyl (meth)acrylate, tetrahydrofurfuryl (meth)acrylate, phenoxyethyl (meth)acrylate, dicyclopentenyl (meth)acrylate, etc.

The weight proportion of the polymerizable prepolymer to the reactive diluent can be arbitrarily varied but is usually in the range of from 10:90 to 80:20 and preferably in the range of from 20:80 to 70:30.

Examples of the photopolymerization initiator include benzoin ether-based compounds, benzophenone-based compounds, acetophenone-based compounds, thioxanthone-based compounds, etc. Specific examples are benzoin isopropyl ether, benzoin isobutyl ether, benzophenone, 2,2-dimethoxy-2-phenylacetophenone, 1-hydroxycyclohexyl phenyl ketone, p-isopropyl-$\alpha$-hydroxyisobutylphenone, $\alpha$-hydroxy isobutyl ketone, 1,1-dichloroacetophenone, 2-chlorothioxanthone, 2-methylthioxanthone, methylbenzoyl formate, etc. These compounds can be used alone or in admixture.

The amount of the photopolymerization initiator is usually in the range of from 0.2 to 20 parts by weight based on 100 parts by weight of the sum of the polymerizable prepolymer and the reactive diluent.

The heat polymerization initiator which can be used in this invention is a mixed system containing from 10 to 50% by weight, based on the whole of the heat polymerization initiator, of an alkyl perester.

Examples of the alkyl perester include tert-butylperoxy 2-ethylhexanoate, tert-butylperoxy isobutylate, di-tert-butylperoxy hexahydroterephthalate, di-tert-butylperoxy azelate, tert-butylperoxy benzoate, etc.

Examples of other heat polymerization initiators in the mixed system are (a) an organic peroxide having an activation energy at pyrolysis of from 30 to 36 kcal/mol; (b) a combination of cumene hydroperoxide and a curing accelerator; and the like.

Examples of the above-described organic peroxide having an activation energy at pyrolysis of from 30 to 36 kcal/mol include bis(4-tert-cyclohexyl) peroxydicarbonate, benzoyl peroxide, 1,1-di-tert-butylperoxy-3,3,5-trimethylcyclohexane, 2,2-di(tert-butylperoxy)-butane, 1,1-di-tert-butylperoxycyclohexane, etc. When the activation energy is less than 30 kcal/mol, the storage stability of the curable composition tends to lower, whereas when it exceeds 36 kcal/mol, not only the heating must be carried out at high temperatures, but also the adhesion strength tends to lower. Accordingly, the object of this invention can be effectively achieved by adjusting the activation energy within the range of from 30 to 36 kcal/mol.

Examples of the curing accelerator which is used in combination with cumene hydroperoxide include metal salts of long-chain organic acids, such as cobalt naphthenate, cobalt octenoate, etc.; amines such as dimethylaniline, N-phenylmorpholine, etc.; quaternary ammonium salts such as triethylbenzylammonium chloride, etc.; and aminophenols such as 2,4,6-tris(dimethylaminomethyl)phenol, etc.

As described above, the heat polymerization initiator which is used in this invention is a mixed system and must contain from 10 to 50% by weight of an alkyl perester. When the amount of the alkyl perester in the heat polymerization initiator is less than 10% by weight based on the whole of the heat polymerization initiator, not only the curing reaction must be carried out at high temperatures, but also the adhesion strength is inferior, whereas when it exceeds 50% by weight, the storage stability and adhesion strength are inferior. In the both cases, the object of this invention cannot be achieved.

The amount of the heat polymerization initiator used is from 0.2 to 15 parts by weight and preferably from 0.5 to 8 parts by weight based on 100 parts by weight of the sum of the polymerizable prepolymer and the reactive diluent. When it is less than 0.2 part by weight, though the storage stability is good, not only the curing requires a long period of time, but also the curing reaction does not proceed sufficiently such that no satisfactory adhesion strength is obtainable. On the other hand, when it exceeds 15 parts by weight, not only the storage stability lowers, but also the curing reaction rapidly proceeds and, at the same time, the resulting polymer is one having a low molecular weight, whereby a brittle product with low adhesion is likely produced.

In the case that a combination of cumene hydroperoxide and a curing accelerator is used as other heat polymerization initiator than the alkyl perester, the curing accelerator is preferably used in an amount of from 2 to 100 parts by weight based on 100 parts by weight of cumene hydroperoxide, depending upon its curing acceleration capacity. If the amount of the curing accelerator is less than 2 parts by weight, the curing reaction must be carried out at high temperatures, whereas if it exceeds 100 parts by weight, the storage stability tends to lower.

The curable composition of this invention can, if desired, contain additives such as chelating agents, heat polymerization inhibitors, coloring agents, thixotropic agents, and inorganic fillers, unless they hinder the object of this invention.

Specific examples of the chelating agent include iminodiacetic acid, N-methyliminodiacetic acid, nitrilotriacetic acid, ethylenediamine-N,N'-diacetic acid, ethylenediamine-N,N,N',N'-tetraacetic acid, N-hydroxyethylethylenediamine-N,N,N'-triacetic acid, and sodium salts thereof as well as N,N,N',N'-2-hydroxypropylethylenediamine, etc.

Examples of the heat polymerization inhibitor include hydroquinone, p-methoxyphenol, benzoquinone, phenothiazine, cupferron, etc.

Examples of the coloring agent include azo-based, phthalocyanine-based, isoindolinone-based and anthraquinone-based coloring agents, carbon black, etc.

Examples of the thixotropic agent include bentonite, ultrafine silica, etc.

Examples of the inorganic filler include silica, talc, alumina, barium sulfate, etc.

The curable composition of this invention is prepared in the following manner. That is, the polymerizable prepolymer, reactive diluent, photopolymerization initiator, heat polymerization inhibitor, chelating agent, etc. are uniformly dissolved in advance, and thereafter, the thixotropic agent, inorganic filler, coloring agent, etc. are mixed and dispersed. The heat polymerization initiator is then added and uniformly mixed. The mixing is usually carried out at not higher than 60°C using a rotary agitator or a three-roll mill.

In the following Examples and Comparative Examples, the measurement and evaluation of the characteristics were carried out as follows.

[Storage Stability]

100 g of the curable composition was placed in a light-shaded 100-ml polyethylene vessel, closed and stored at 40°C. There was investigated the number of days elapsed before the gelation occurred.

Symbols used for the evaluation have the following meanings.

○: 6 days or more
△: 5 to 4 days
×: 3 days or less

[Curing Properties]

In accordance with the method defined in JIS K-6901, the sample was dipped in an oil bath at 120°C, and the time (minute) required for the resin temperature to reach a maximum temperature was measured.

Symbols used for the evaluation have the following meanings.

○: less than 2 minutes
△: 2 to 5 minutes
×: more than 5 minutes

[Adhesion Strength]

The curable composition was applied in an amount of from about 0.3 to 0.5 mg onto a printed circuit board and, after a multilayer ceramic chip capacitor (3.2 mm×1.6 mm) was mounted in the central part thereof, the assembly was irradiated with an ultraviolet light for 20 seconds at a distance of 20 cm from a high-pressure mercury vapor lamp having a power input of 80 W/cm. Immediately thereafter, the assembly was heated for 10 minutes in an atmosphere at 120° C. Then, the shear adhesion strength (kg) per chip was measured at room temperature.

Symbols used for the evaluation have the following meanings.

O: 3 kg or more

Δ: 1 kg or more but less than 3 kg

×: less than 1 kg

In the following examples, all parts are a part by weight.

## EXAMPLES 1 AND 2 AND COMPARATIVE EXAMPLES 1 TO 4

Each of Mixture A (for Example 1 and Comparative Examples 1 to 3) and Mixture B (for Example 2 and Comparative Example 4) was prepared by thoroughly stirring the following components with a formulation ratio indicated below.

| Formulation of Mixture A | |
|---|---|
| Unsaturated polyester having a molecular weight of about 2,500 (made by Nippon Upica Co., Ltd.; Upica® 8554) | 100 parts |
| Bifunctional acrylate (made by Okamura Seiyu Co., Ltd.; ULB-20GEA) | 71 parts |
| Tetrahydrofurfuryl methacrylate | 100 parts |
| Photopolymerization initiator (made by Ciba Geigy AG; Irgacure® 651) | 8.6 parts |
| Polymerization inhibitor (p-methoxyphenol) | 0.3 part |
| Inorganic filler (talc) | 200 parts |

| Formulation of Mixture B | |
|---|---|
| Unsaturated polyester having a molecular weight of about 2,500 (made by Nippon Upica Co., Ltd.; Upica® 8554) | 100 parts |
| Tris(acryloxyethyl) isocyanurate | 30 parts |
| Bifunctional acrylate (made by Okamura Seiyu Co., Ltd.; ULB-20GEA) | 71 parts |
| Tetrahydrofurfuryl methacrylate | 100 parts |
| Photopolymerization initiator (made by Ciba Geigy AG; Irgacure® 651) | 8.6 parts |
| Polymerization inhibitor (p-methoxyphenol) | 0.3 part |
| Chelating agent (trisodium N-hydroxyethylethylenediamine-N,N′,N′-triacetate) | 0.2 part |
| Inorganic filler (talc) | 200 parts |

100 parts of each of Mixtures A and B was added with the heat polymerization initiator as shown in Table 1 and stirred at not higher than 40° C to prepare a curing composition.

The characteristics of the resulting curing composition were examined and evaluated. The results are shown in Table 1.

5

## Table 1

| | Example No. and Comparative Example No. | | | | | |
|---|---|---|---|---|---|---|
| | Example 1 | Comparative Example 1 | Comparative Example 2 | Comparative Example 3 | Example 2 | Comparative Example 2 |
| [Heat polymerization initiator] | | | | | | |
| tert-Butylperoxy 2-ethylhexanoate | 1 | - | 4 | 1 | 1 | - |
| 1,1-Di-tert-butylperoxy-3,3,5-trimethylcyclohexane | 3 | 4 | - | - | - | - |
| 2,2-Di(tert-butylperoxy)butane | - | - | - | 3 | - | - |
| Cumene hydroperoxide | - | - | - | - | 3 | 3 |
| Triethylbenzylammonium chloride | - | - | - | - | 1 | 1 |
| [Characteristics] | | | | | | |
| Storage stability | O | O | × | O | O | O |
| Curing properties | O | × | O | × | O | × |
| Adhesion strength | O | × | △ | × | O | △ |

EP 0 314 132 A2

As is clear from Table 1, it can be understood that the curable compositions of the Examples of this invention are markedly superior to those of the Comparative Examples.

While the invention has been described in detail and with reference to specific embodiments thereof, it will be apparent to one skilled in the art that various changes and modifications can be made therein without departing from the spirit and scope thereof.

## Claims

1. A curable composition comprising a polymerizable prepolymer, a reactive diluent, a photopolymerization initiator, and a heat polymerization initiator, wherein said heat polymerization initiator is a mixed system containing from 10 to 50% by weight, based on the whole of the heat polymerization initiator, of an alkyl perester.

2. A curable composition as in claim 1, wherein said alkyl perester is tert-butylperoxy-2-ethylhexanoate, tert-butylperoxy isobutylate, di-tert-butylperoxy hexahydroterephthalate, di-tert-butylperoxy azelate, or tert-butylperoxy benzoate.

3. A curable composition as in claim 1, wherein said alkyl perester is tert-butyloxy 2-ethylhexanoate.

4. A curable composition as in claim 1, where other heat polymerization initiator than said alkyl perester is an organic peroxide having an activation energy at pyrolysis of from 30 to 36 kcal/mol or a combination of cumene hydroperoxide and a curing accelerator.

5. A curable composition as in claim 4, wherein said organic peroxide is 1,1,-di-tert-butylperoxy-3,3,5-trimethylcyclohexane.

6. A curable composition as in claim 4, wherein said curing accelerator is a metal salt of a long-chain organic acid, an amine, a quaternary ammonium salt, or an aminophenol.

7. A curable composition as in claim 4, wherein said curing accelerator is used in an amount of from 2 to 100 parts by weight based on 100 parts by weight of said cumene hydroperoxide.

8. A curable composition as in claim 1, wherein said heat polymerization initiator is used in an amount of from 0.2 to 15 parts by weight based on 100 parts by weight of the sum of said polymerization prepolymer and said reactive diluent.

9. A curable composition as in claim 8, wherein said heat polymerization initiator is used in an amount of from 0.5 to 8 parts by weight based on 100 parts by weight of the sum of said polymerization prepolymer and said reactive diluent.

10. A curable composition as in claim 1, wherein the weight proportion of said polymerizable prepolymer to said reactive diluent is from 10:90 to 90:10.

11. A curable composition as in claim 10, wherein the weight proportion of said polymerizable prepolymer to said reactive diluent is from 20:80 to 70:30.

12. A curable composition as in claim 1, wherein said photopolymerization initiator is used in an amount of from 0.2 to 20 parts by weight based on 100 parts by weight of the sum of said polymerizable prepolymer and said reactive diluent.